**Europäisches Patentamt**

**European Patent Office**

**Office européen des brevets**

(19)

(11) Veröffentlichungsnummer: **0 191 440
B1**

(12) ## EUROPÄISCHE PATENTSCHRIFT

(45) Veröffentlichungstag der Patentschrift:
**24.05.89**

(21) Anmeldenummer: **86101630.1**

(22) Anmeldetag: **07.02.86**

(51) Int. Cl.⁴: **H01J 37/317,** H01J 37/30,
H01J 37/09

(54) Lithografiegerät zur Erzeugung von Mikrostrukturen.

(30) Priorität: **12.02.85 DE 3504714**

(43) Veröffentlichungstag der Anmeldung:
**20.08.86 Patentblatt 86/34**

(45) Bekanntmachung des Hinweises auf die Patenterteilung:
**24.05.89 Patentblatt 89/21**

(84) Benannte Vertragsstaaten:
**DE FR GB IT NL**

(56) Entgegenhaltungen:
**EP-A- 0 043 351**

**IEEE TRANSACTIONS ON ELECTRON DEVICES, Band ED-26, Nr. 4, April 1979, Seiten 663-674, IEEE, New York, US; H.C. PFEIFFER: "Recent advances in electron-beam lithography for the high-volume production of VLSI devices"
ELECTRONICS, Band 56, Nr. 21, 20. Oktober 1983, Seiten 86-87, New York, US; J. GOSCH: "Electron beam writes 10 billion pixels/s"
SIEMENS FORSCHUNGS- UND ENTWICKLUNGS-BERICHTE, Band 9, Nr. 3, 1980, Springer-Verlag, Berlin, DE; K. ANGER et al.: "Design and tesing of a corrected projection lens system for electron-beam lithography"**

(73) Patentinhaber: **Siemens Aktiengesellschaft Berlin und München, Wittelsbacherplatz 2, D-8000 München 2(DE)**

(72) Erfinder: **Lischke, Burkhard, Prof. Dr., In der Heuluss 13, D-8000 München 82(DE)**

## Beschreibung

Die Erfindung bezieht sich auf ein Lithografiegerät zur Erzeugung von Mikrostrukturen, insbesondere für Halbleiter, nach dem Oberbegriff des Patentanspruchs 1.

Ein solches Gerät ist aus den IEEE Transactions on Electron Devices, Vol. ED-26, No. 4, April 1979, S. 663-674, insbesondere Figuren 3 und 4, bekannt. Hierbei kann infolge des gleichzeitigen Einsatzes mehrerer Korpuskularstrahlsonden ein höherer Durchsatz von belichteten Halbleiterstrukturen erwartet werden, als bei einem Lithografiegerät mit nur einer Sonde, die eine zu strukturierende Fläche rasterförmig überstreicht. Die Herstellung von Halbleiterstrukturen mittels eines Lithografiegeräts ist z.B. in den Siemens Forschungs- und Entwicklungsberichten, Bd. 9 (1980) Nr. 3, S. 174-178, beschrieben. Hierzu sei insbesondere auf Fig. 8 und den zugehörigen Text auf Seite 178 hingewiesen.

Bei dem aus den IEEE Transactions bekannten Lithografiegerät kann jede einzelne Korpuskularstrahlsonde durch Anlegen einer Austastspannung an einen Ablenkkondensator, dessen Elektroden randseitig zu der betreffenden sondenerzeugenden Ausnehmung der Aperturblende angeordnet sind, soweit abgelenkt werden, daß sie auf die Austastblende trifft und somit aus dem weiteren Strahlengang ausgetastet wird. Nachteilig ist jedoch, daß die sondenerzeugenden Ausnehmungen, deren Abmessungen sehr klein sind im Vergleich zu den Abmessungen der von der Korpuskularstrahlquelle beleuchteten Kreisfläche auf der Aperturblende, nur relativ kleine Sondenströme zulassen. Jede Verkleinerung des Sondenstroms führt aber zu einer Vergrößerung der Belichtungszeiten für die von den Korpuskularstrahlsonden überstrichenen Punkte des zu belichtenden Resists, so daß der zu erwartende höhere Durchsatz (gegenüber dem eines Lithografiegeräts mit einer einzigen rasterförmig abgelenkten Sonde) nur teilweise erreicht wird.

Der Erfindung liegt die Aufgabe zugrunde, ein Lithografiegerät der eingangs genannten Art anzugeben, das einen wesentlich höheren Durchsatz von belichteten Mikrostrukturen ermöglicht als das vorstehend erwähnte, bekannte Lithografiegerät. Das wird erfindungsgemäß durch eine Ausbildung des Lithografiegeräts nach dem kennzeichnenden Teil des Patentanspruchs 1 erreicht.

Der mit der Erfindung erzielbare Vorteil liegt insbesondere darin, daß die Korpuskularstrahlsonden trotz kleiner Abmessungen der sondenerzeugenden Ausnehmungen einen relativ hohen Sondenstrom führen und deswegen eine hohe Belichtungsgeschwindigkeit für die einzelnen Punkte des Resists zulassen.

Die Ansprüche 2 bis 16 sind auf vorteilhafte Ausgestaltungen und Weiterbildungen des Lithografiegeräts nach der Erfindung gerichtet.

Die Erfindung wird nachfolgend anhand der Zeichnung näher erläutert. Dabei zeigt:

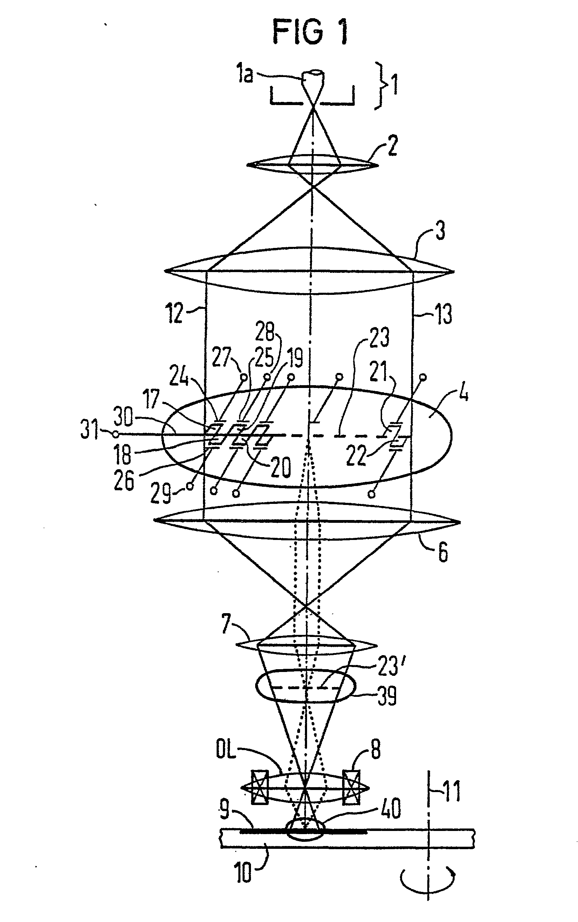

Fig. 1 die Prinzipdarstellung eines erfindungsgemäßen Lithografiegeräts,

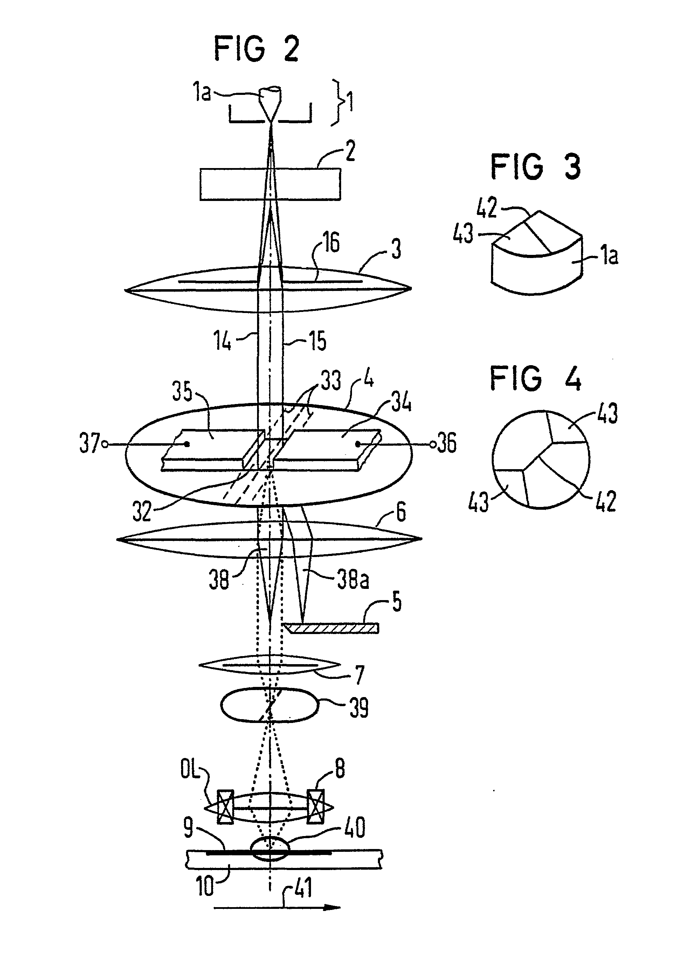

Fig. 2 eine weitere Darstellung desselben Geräts,

Fig. 3 eine Einkristallkathode für das Gerät nach Fig. 1,

Fig. 4 eine Draufsicht auf die Einkristallkathode nach Fig. 3,

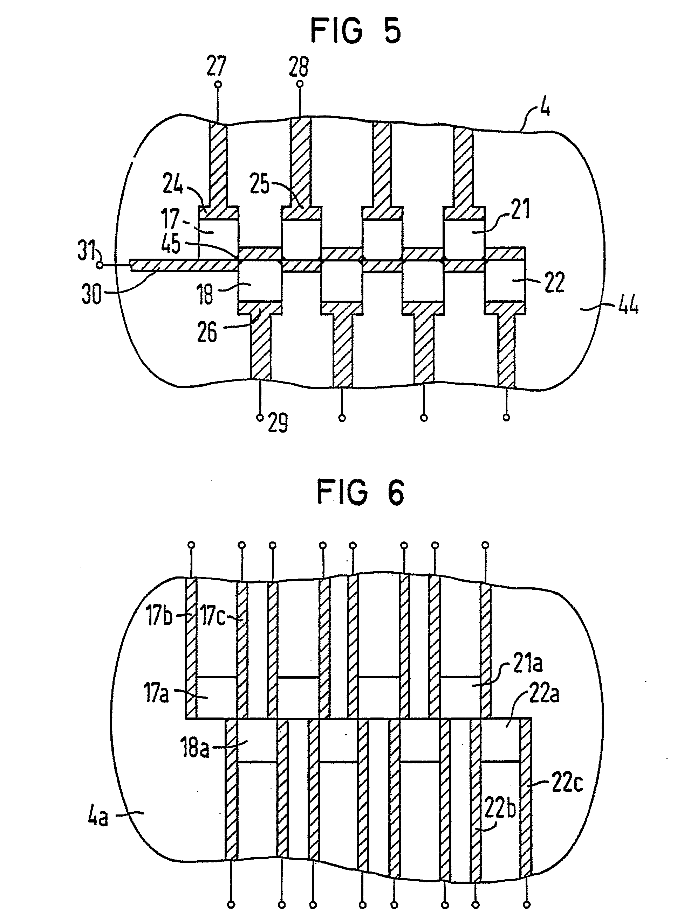

Fig. 5 eine bevorzugte Ausbildung der steuerbaren Aperturblende des Geräts nach Fig. 1,

Fig. 6 eine zusätzliche Aperturblende, die in Verbindung mit einer Blende nach Fig. 5 eingesetzt werden kann, und

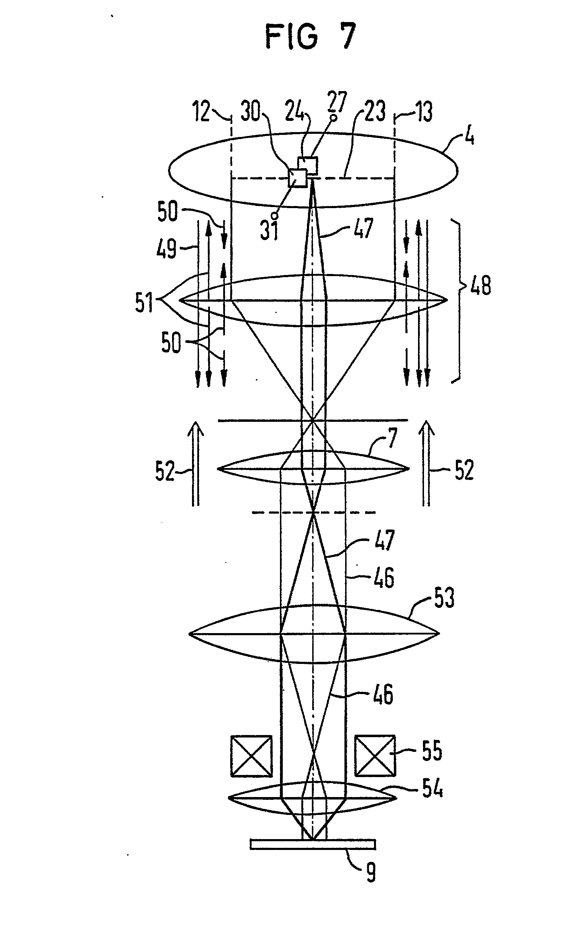

Fig. 7 eine Weiterbildung des Geräts nach Fig. 1, mit der der Abbildungsmaßstab verändert werden kann.

Das in den Figuren 1 und 2 schematisch dargestellte Lithografiegerät umfaßt eine Elektronenstrahlquelle 1, eine Zylinderlinse 2, eine Kondensorlinse 3, eine steuerbare Aperturblende 4, eine Austastblende 5, eine aus Linsen 6, 7 und einer Objektivlinse OL bestehende Abbildungsoptik und ein Ablenksystem 8, unter dem sich ein zu strukturierender Körper 9, insbesondere Halbleiterkörper, befindet. Dieser ist auf einem Tisch 10 befestigt, der zweckmäßigerweise um eine vertikale Achse 11 drehbar gelagert ist.

Die aus einer Kathode 1a austretenden Elektronenstrahlen werden durch die Zylinderlinse 2 und die Kondensorlinse 3 zu einem Bandstrahl zusammengefaßt, der in der Ansicht nach Fig. 1 durch die Randstrahlen 12 und 13 begrenzt ist. Senkrecht dazu, d.h. in der Ansicht nach Fig. 2, weist er die Randstrahlen 14 und 15 auf. Wie hieraus hervorgeht, ist der Querschnitt des Bandstrahls parallel zur Bildebene von Fig. 1 wesentlich größer bemessen als parallel zur Bildebene von Fig. 2. Zwischen der Zylinderlinse 2 und der Kondensorlinse 3 ist zweckmäßigerweise eine Spaltblende 16 vorgesehen, die eine Begrenzung des Bandstrahls auf die Randstrahlen 14 und 15 bewirkt.

Die scheibenförmig ausgebildete Aperturblende 4 ist mit einer zeilenförmigen Mehrlochstruktur versehen. Bei der Ausführungsform nach Fig. 1 sind hierfür rechteckige oder quadratische Ausnehmungen 17 bis 22 vorgesehen, die jeweils von einer mittleren, gestrichelten Linie 23 ausgehen und abwechselnd nach der einen und anderen Seite versetzt sind. Im einzelnen liegen die Ausnehmungen 17, 19 ... 21 auf der einen und die Ausnehmungen 18, 20 ... 22 auf der anderen Seite von 23. An den der Linie 23 gegenüberliegenden Seiten der Ausnehmungen befinden sich jeweils Elektroden 24 bis 26, die mit Anschlüssen 27 bis 29 verbunden sind. Eine weitere Elektrode 30 erstreckt sich entlang der Linie 23 und stellt eine für alle Ausnehmungen gemeinsame Gegenelektrode dar. Sie ist mit einem Anschluß 31 verbunden.

Bei der Ausführungsform nach Fig. 2 besteht die Mehrlochstruktur aus einer Reihe von rechteckigen oder quadratischen Ausnehmungen 32, die entlang der Linie 23 liegen, ohne gegeneinander versetzt zu sein. Aus Gründen der besseren Darstellung ist nur eine Ausnehmung 32 stark vergrößert gezeigt, wobei die übrigen Ausnehmungen durch gestrichelte Linien 33 angedeutet sind. Auch hier sind randseitig zu den Ausnehmungen 32 jeweils Elektroden 34 und 35 angeordnet, die mit Anschlüssen 36 und 37 verbunden sind.

Der Bandstrahl ist ausgerichtet, daß seine größte Querschnittsabmessung, die durch die Randstrahlen 12 und 13 gegeben ist, in Richtung der Linie 23 liegt, während seine kleinste Abmessung hierzu senkrecht liegt und der Breite der Mehrlochstruktur unter Berücksichtigung eines etwaigen gegenseitigen Versatzes der Ausnehmungen (Fig. 1) entspricht oder diese nur geringfügig übersteigt. Damit ist gewährleistet, daß nur der unmittelbare Bereich der Mehrlochstruktur durch den Bandstrahl beleuchtet wird, so daß ein großer Teil der von der Elektronenstrahlquelle 1 abgegebenen Energie für die Ausformung der Elektronenstrahlsonden zur Verfügung steht. Jede dieser Sonden besteht aus einem durch eine der Ausnehmungen 17 bis 22 oder 32 hindurchtretenden Teil des Bandstrahls. In Fig. 2 ist die durch die Ausnehmung 32 geformte Elektronenstrahlsonde mit 38 bezeichnet. Schaltet man an die Anschlüsse 36 und 37 eine Spannung, durch die die Elektrode 34 auf ein positiveres Potential gelegt wird als die Elektrode 35, so wird die Sonde 38 in die Lage 38a abgelenkt und dadurch von der Austastblende 5 aufgefangen, so daß sie aus dem weiteren Strahlengang ausgeblendet ist. Jede nicht abgelenkte Sonde, z.B. 38, steht zur Belichtung der Oberfläche des Körpers 9 oder eines auf diesem aufgebrachten Resists zur Verfügung. Zur Ausblendung einer gemäß Fig. 1 durch die Ausnehmung 17 gebildeten Sonde wird der Elektrode 24 eine positive Spannung zugeführt, während die Elektrode 31 auf Bezugspotential gelegt ist. Soll eine durch die Ausnehmung 18 gebildete Sonde ausgeblendet werden, so wird an die Elektrode 26 eine negative Spannung gelegt. Bei Ausbildung von 5 als Schlitzblende ist an 26 auch eine positive Spannung zulässig.

Wie sich aus den eingezeichneten Strahlengängen ergibt, werden die Sondenquerschnitte, die in der Ebene der Aperturblende 4 durch die Abmessungen der Ausnehmungen, z.B. 17, gegeben sind, mittels der Linsen 6 und 7 in eine Ebene 39 verkleinert abgebildet, was einer Reduzierung der Linie 23 auf eine Linie 23¹ entspricht. Die Objektivlinse OL bildet dann die Querschnitte der Elektronenstrahlsonden verkleinert auf die Oberfläche des Körpers 9 ab, was durch 40 angedeutet ist.

Die Strukturerzeugung auf dem Körper 9 erfolgt nach Fig. 1 so, daß die Gesamtheit aller nicht ausgetasteten Elektronenstrahlsonden nach dem Belichten der durch sie getroffenen Punkte des Körpers 9 oder eines diesen bedeckenden Resists beispielsweise mittels des Ablenksystems 8 in einer zur Projektion der Linie 23 etwa senkrechten Richtung relativ zum Körper 9 bewegt wird, und zwar um eine Sondenabmessung. Die so aufgesuchte, benachbarte Sondenzeile wird dann in analoger Weise belichtet. Durch individuelle Ansteuerung der Elektroden auf der Aperturblende kann ein beliebiges Belichtungsmuster auf der Oberfläche von 9 erzeugt werden, dessen kleinstes Strukturdetail der Querschnittsabmessung einer Sonde, gemessen auf der Oberfläche von 9, entspricht. Für Fig. 2 gilt dementsprechend, daß die Gesamtheit der nicht ausgetasteten Sonden nach einem Belichtungsvorgang jeweils um eine projizierte Sondenabmessung relativ zum Körper 9 verschoben wird, was durch den Pfeil 41 angedeutet ist.

Die gepunkteten Strahlengänge der Figuren 1 und 2 veranschaulichen die Abbildung der Ausnehmungen 17 uswq. der Aperturblende 4 auf die Oberfläche des Körpers 9.

Fig. 3 zeigt eine bevorzugte Ausgestaltung der Kathode 1a, und zwar in Form einer Einkristallbolzenkathode aus Lanthanhexaborid (LaB₆), die in eine Schneide 42 ausläuft. Diese Form wird z.B. dadurch erhalten, daß eine zylindrische Bolzenkathode zunächst von zwei Seiten her angeschliffen wird, so daß eine Schneide 42 entsteht, deren Länge dem Durchmesser des Bolzens entspricht, und daß anschließend zwei weitere Flächen 43 angeschliffen werden, die dann zwischen sich die Länge der Schneide 42 bestimmen. In der Draufsicht nach Fig. 4 sind die Schneide 42 und die Flächen 43 deutlich erkennbar. Die angeschliffenen Flächen entsprechen dabei vorzugsweise 100 -Ebenen des Kristalls, oder anderen Ebenen, die Flächen mit niedriger Austrittsarbeit darstellen.

Fig. 5 zeigt eine bevorzugte Ausführungsform der Aperturblende 4. Dabei ist eine hochohmige Substratfolie, z.B. aus Silizium, mit den bereits beschriebenen Ausnehmungen 17 bis 22 versehen. Die zur Sondenaustastung dienenden Elektroden 24, 25, 26 usw. sind als endseitig verbreiterte Leiterbahnen ausgeführt, die z.B. aus Gold bestehen. Die gemeinsame Elektrode 30 besteht vorzugsweise ebenfalls aus Gold und verläuft mäanderförmig zwischen den Ausnehmungen, wobei sie mit genügend breiten Zwischenstegen 45 versehen ist, um einen guten Kontakt zwischen ihren einzelnen Teilen zu erreichen. Die der Elektronenstrahlquelle 1 zugekehrte Oberfläche von 4 ist außerhalb der Lochstrukturen mit einer leitenden Belegung versehen, über die die auftreffenden Elektronen abgeleitet werden.

Nach einer vorteilhaften Weiterbildung kann die Aperturblende 4 durch eine weitere Aperturblende 4a gemäß Fig. 6 ergänzt werden. Diese besteht auch aus einer hochohmigen Substratfolie und weist Ausnehmungen 17a bis 22a auf, die bei einer genauen gegenseitigen Justierung der Blenden mit den Ausnehmungen 17 bis 22 zusammenfallen. Randseitig zu den Ausnehmungen zu 17a bis 22a sind jeweils zwei Elektroden 17b, 17c bis 22b, 22c vorgesehen, die mit Anschlüssen verbunden sind. An diese können Spannungen angelegt werden, die eine Ablenkung der Elektronenstrahlsonden parallel zur Längsrichtung der zeilenförmigen Mehrlochstruktur bewirken, um optische Fehler (z.B. Öffnungsfehler der Kondensorlinsen, Verzeichnungen der Abbildungsoptik usw.) zu korrigieren. Die Elektrodenstrukturen von 4a sind mit Vorteil ebenfalls als Leiterbahnen ausgeführt und bestehen z.B. aus Gold. Die Herstellung der Aperturblenden 4, 4a kann in Planartechnik mit üblichen Lithografiemethoden erfolgen.

Mit besonderem Vorteil können die in der beschriebenen Weise ausgebildeten Aperturblenden 4 bzw. 4a für eine große Anzahl von Ausnehmungen 17 usw. ausgelegt sein. Beispielsweise sind 2048 Ausnehmungen denkbar, mit denen eine entsprechende Anzahl von Elektronenstrahlsonden erzeugt werden. Geht man von einer quadratischen Form der Ausnehmungen 17 usw. mit einer Seitenlänge von 10 µm aus und verkleinert die Sondenabmessung mit Hilfe der Abbildungsoptik um den Faktor 100, so ergeben sich einzelne belichtbare Bildpunkte mit einer Seitenlänge von 0,1 µm. Bei einem Sondenstrom von etwa 5 nA für jede Sonde wird dann bei einer Lackempfindlichkeit $C = 10^{-5}As/cm^2$ eine Belichtungsgeschwindigkeit von etwa 1 cm²/s erreicht, was einem Durchsatz von etwa fünfzig 4"-Halbleiterscheiben pro Stunde entspricht. Die Länge der Mehrfachlochstruktur auf der Aperturblende 4 beträgt dabei etwa 20,5 mm. Mit einem derartigen Gerät lassen sich z.B. Strukturen im 0,1 µm-Bereich erzeugen, wie sie etwa für integrierte Schaltungen auf GaAs-Basis oder für Komponenten der optischen Nachrichtentechnik, z.B. Gitterstrukturen für Festkörperlaser, erforderlich sind.

Für unterschiedliche Rastermaße der zu erzeugenden Strukturen können unterschiedliche Aperturblenden vorgesehen sein, deren Ausnehmungen entsprechend dimensioniert und angeordnet sind. Man kann aber auch mit einer bestimmten Aperturblende Strukturen erzeugen, die ein von dem durch die Blende vorgegebenen Rastermaß abweichendes Rastermaß haben, insbesondere wenn die Abweichungen im %-Bereich liegen. Hierzu wird eine in Figur 7 dargestellte Weiterbildung des erfindungsgemäßen Lithografiegeräts mit veränderbarem Abbildungsmaßstab verwendet.

In Fig. 7 sind nur die unterhalb der Aperturblende 4 liegenden Teile des Gerätes dargestellt. Oberhalb von 4 befinden sich dabei die gleichen Teile wie bei der Anordnung nach Fig. 1. Die Elektroden 24 und 30, die randseitig zu der im einzelnen nicht dargestellten Ausnehmung 17 angeordnet sind, werden hier als Platten eines Kondensators angedeutet. Der Beleuchtungsstrahlengang ist mit 46 bezeichnet, während 47 den Strahlengang zur Abbildung der Ausnehmung 17 auf die Oberfläche von 9 darstellt. Die Veränderung des Abbildungsmaßstabs erfolgt mittels einer Zoom-Linse 48, die an die Stelle der Linse 6 von Fig. 1 tritt. Eine solche Linse ist an sich bereits auf Seite 177 der obengenannten Siemens Forschungs- und und Entwicklungs-Berichte (insbesondere Fig. 6 und zugehöriger Text) erwähnt. Sie besitzt eine Hauptwicklung 49, die durch drei symmetrisch zu ihrer Längsachse liegende, eine Brennweitenverstellung bewirkende Zusatzwicklungen 50 ergänzt ist. Werden die Zusatzwicklungen so angespeist, daß die mittlere von ihnen das von 49 erzeugte Hauptfeld schwächt, während die untere und die obere Zusatzwicklung 50 dieses Hauptfeld verstärken, ergibt sich eine Verformung des Hauptfeldes, die einer größeren Brennweite von 48 entspricht. Bei einer Umkehrung dieser Einflußnahmen ergibt sich eine Verkleinerung der Brennweite. Die wirksame Linsenerregung bleibt hierbei unbeeinflußt. Zwei weitere, ebenfalls symmetrisch zu Längsachse der Linse 48 angeordnete Wicklungen 51 bewirken zusätzliche Veränderungen des Linsenfeldes, die einer Längsverschiebung der Linsenteile 49 und 50 in Richtung auf die Aperturblende 4 oder in Gegenrichtung äquivalent sind. Falls das Hauptfeld von 48 durch die obere Wicklung 51 geschwächt und durch die untere Wicklung 51 verstärkt wird, ergibt sich die Wirkung einer Längsverschiebung von 48 nach unten, bei einer Umkehrung dieser Einflußnahmen auf das Hauptfeld eine solche nach oben. Wird nun die Brennweite von 48 verkleinert und dabei eine Verschiebung des Linsenhauptfeldes in Richtung auf die Aperturblende 4 mit einem dieser Verkleinerung entsprechenden Betrag vorgenommen, so nimmt die durch die Linsen 48 und 7 bewirkte Verkleinerung der auf 9 projizierten Ausnehmungen 17 usw. ab, wobei gleichzeitig der für die Belichtung wirksame Sondenquerschnitt zunimmt, so daß sich eine Vergrößerung des Rastermaßes der zu erzeugenden Struktur ergibt. Eine Umkehrung der Einflußnahmen auf das Hauptfeld von 48 bewirkt dann eine Verkleinerung des Strukturrastermaßes.

Mit Vorteil weisen die Linsen 48 und 7 einen telezentrischen Strahlengang und entgegengesetzt gleiche Erregungen auf, was durch die Pfeile 52 angedeutet ist. Hierdurch werden Verdrehungsfarbfehler, Vergrößerungsfarbfehler und isotrope Verzeichnungen des Linsensystems 48, 7 praktisch vermieden.

Die Abbildungsoptik wird in Fig. 7 noch durch zwei Linsen 53 und 54 ergänzt, zwischen denen sich das Ablenksystem 55 befindet. Auch die Linsen 53 und 54 sind vorzugsweise mit telezentrischem Strahlengang und entgegengesetzt gleicher Erregung ausgeführt, um die genannten Fehler zu beseitigen. Eine derartige Ausbildung von Linsenpaaren ist der DE-PS 25 15 549 entnehmbar. Durch Verwendung des Bandstrahls wird zusätzlich der Boersch-Effekt minimiert.

Die Relativbewegung zwischen der Gesamtheit der Elektronenstrahlsonden und dem Körper 9 kann nach einer weiteren Ausgestaltung der Erfindung auch durch eine Bewegung des Tisches 10 erzielt werden. Hierzu eignet sich auch eine insbesondere kontinuierliche Drehbewegung, die beispielsweise um die Achse 11 erfolgt. Damit kann in einfacher Weise der nach obigem Beispiel errechneten Bestrahlungsgeschwindigkeit von etwa 1 cm²/s Rechnung getragen werden.

Für den Fall, daß die Aperturblende 4 nach Fig. 2 eine Reihe von gegeneinander nicht versetzten Ausnehmungen 32 aufweist, deren gegenseitige Abstände der Seitenlänge einer Ausnehmung entsprechen, muß nach jedem einzelnen Belichtungsvorgang innerhalb der gleichen Zeileneinstellung der Elektronenstrahlsonden eine Verschiebung der letzteren um diese Seitenlänge in Richtung der Linie 23 erfolgen, damit eine vollständige Belichtung des Körpers 9 gewährleistet ist. Diese Verschiebung wird mit Vorteil mittels des Ablenksystems 8 bzw. 55 vorgenommen.

Die Erfindung umfaßt nicht nur die beschriebenen Ausführungsformen, bei denen Elektronenstrahlsonden verwendet werden, sondern auch andere Korpuskularstrahl-Lithografiegeräte, die z.B. mit Ionenstrahlsonden arbeiten.

Bezugszeichenliste

1 Elektronenstrahlquelle
1a Kathode
2 Zylinderlinse
3 Kondensorlinse
4 steuerbare Aperturblende
4a weitere Aperturblende
5 Austastblende
6 Linse
7 Linse
8 Ablenksystem
9 zu strukturierender Körper
10 Tisch
11 Achse
12–15 Randstrahlen
16 Spaltblende
17–22 Ausnehmungen
17a–22a Ausnehmungen
17b, 22b Elektroden
17c, 22c Elektroden
23 mittlere Linie
23' mittlere Linie in der Ebene 39
24–26 Elektroden
27–29 Anschlüsse
30 gemeinsame Elektrode
31 Anschluß
32 Ausnehmungen
33 gestrichelte Linien
34, 35 Elektroden
36, 37 Anschlüsse
38 Elektronenstrahlsonde
38a abgelenkte Lage der Elektrodenstrahlsonde
39 Ebene
40 Abbildungsverkleinerung
41 Pfeil
42 Schneide
43 Flächen
45 Zwischenstege
46 Beleuchtungsstrahleingang
47 Strahlengang
48 Zoom-Linse
49 Hauptwicklung
50 Zusatzwicklungen
51 weitere Wicklungen
52 Pfeile
53, 54 Linsen
55 Ablenksystem
OL Objektivlinse

**Patentansprüche**

1. Lithografiegerät zur Erzeugung von Mikrostrukturen auf einem Körper, insbesondere Halbleiterkörper (9) mit einer Korpuskularstrahlquelle, einem Kondensorlinsensystem (2, 3), einer steuerbaren Aperturblende (4) mit einer zeilenförmigen Mehrlochstruktur (17 ... 22) zur Erzeugung einer Mehrzahl von Korpuskularstrahlsonden, einer Austastblende (5) und einer Abbildungsoptik (6, 7, OL), dadurch gekennzeichnet, daß die Korpuskularstrahlen einen Bandstrahl bilden, dessen größte Querschnittsabmessung (12, 13) etwa in Längsrichtung (23) der zeilenförmigen Mehrlochstruktur (17 ... 22) liegt und dessen kleinste Querschnittsabmessung die Breite der Mehrlochstruktur nicht wesentlich übersteigt.

2. Lithografiegerät nach Anspruch 1, dadurch gekennzeichnet, daß zwischen der Korpuskularstrahlquelle (1) und der Aperturblende (4) eine den Bandstrahl erzeugende Zylinderlinse (2) vorgesehen ist.

3. Lithografiegerät nach einem der Ansprüche 1 oder 2, dadurch gekennzeichnet, daß die Korpuskularstrahlquelle (1) eine bolzenförmige Einkristallkathode (1a) enthält, die schneidenförmig ausgebildet ist.

4. Lithografiegerät nach Anspruch 3, dadurch gekennzeichnet, daß die bolzenförmige Einkristallkathode (1a) aus LaB$_6$ besteht.

5. Lithografiegerät nach einem der Ansprüche 1 bis 4, dadurch gekennzeichnet, daß die Mehrlochstruktur der Aperturblende (4) wenigstens annähernd rechteckige oder quadratische Ausnehmungen (17 ... 22) umfaßt, die von einer mittleren Linie (23) ausgehen und jeweils abwechselnd nach der einen und der anderen Seite versetzt sind, und daß an den zu der mittleren Linie (23) parallel liegenden Seiten jeder Ausnehmung (17) Elektroden (24, 30) zur Ablenkung der durch diese Ausnehmung erzeugten Korpuskularstrahlsonde angeordnet sind.

6. Lithografiegerät nach einem der Ansprüche 1 bis 4, dadurch gekennzeichnet, daß die Mehrlochstruktur der Aperturblende (4) wenigstens annähernd rechteckige oder quadratische Ausnehmungen (32) umfaßt, die entlang einer Linie (23) angeordnet sind und gegenseitige Abstände aufweisen, die ihren Abmessungen in Richtung der Linie (23) entsprechen, und daß an den zu der Linie parallelen Seiten jeder Ausnehmung (32) Elektroden (34, 35) zur Ablenkung der durch diese Ausnehmung (32) erzeugten Korpuskularstrahlsonde angeordnet sind.

7. Lithografiegerät nach einem der Ansprüche 5 oder 6, dadurch gekennzeichnet, daß die Aperturblende aus einem hochohmigen Substrat, insbesondere Silizium oder Siliziumoxid, besteht, auf dem die Elektroden (24, 30, 34, 35) in Form von Leiterbahnen aufgebracht sind, welche mit Anschlüssen für die Zuführung von Austastspannungen versehen sind.

8. Lithografiegerät nach Anspruch 7, dadurch gekennzeichnet, daß die Leiterbahnen aus Gold bestehen.

9. Lithografiegerät nach Anspruch 5, dadurch gekennzeichnet, daß die im Bereich der mittleren Linie (23) angeordneten Elektroden einiger oder aller Ausnehmungen (17 ... 22) zu einer gemeinsamen Elektrode (30) zusammengefaßt sind, wobei die Elektroden durch Zwischenstege miteinander verbunden sind.

10. Lithografiegerät nach einem der Ansprüche 7 bis 9, dadurch gekennzeichnet, daß das Substrat auf der der Korpuskularstrahlquelle (1) zugewandten Seite außerhalb der Mehrloch struktur mit einer leitenden Belegung zur Ableitung der auftreffenden Korpuskeln versehen ist.

11. Lithografie gerät nach einem der Ansprüche 5 bis 10, dadurch gekennzeichnet, daß eine weitere Aperturblende (4a) mit weiteren Ausnehmungen (17a ... 22a) versehen ist, die den Ausnehmungen (17 ... 22) der Aperturblende (4) lagemäßig entsprechen und von den durch die letzteren erzeugten Korpuskularstrahlsonden durchdrungen werden und daß an den senkrecht zur Linie bzw. mittleren Linie (23) der Mehrlochstruktur verlaufenden Seiten der weiteren Ausnehmungen (17a ... 22a) weitere Elektroden (17b, 17c ... 22b, 22c) vorgesehen sind, die zur Ablenkung der Korpuskularstrahlsonden in Richtung der Linie bzw. mittleren Linie (23) dienen.

12. Lithografiegerät nach einem der Ansprüche 1 bis 11, dadurch gekennzeichnet, daß zur Veränderung des Abbildungsmaßstabes zwischen der Aperturblende (4) und dem Halbleiterkörper (9) eine magnetische oder elektrische Zoom-Linse (48) vorgesehen ist, deren Brennweite und effektiver Abstand von der Aperturblende (4) gleichsinnig variierbar sind.

13. Lithografiegerät nach Anspruch 12, dadurch gekennzeichnet, daß die Zoom-Linse (48) neben der das Hauptfeld erzeugenden Wicklung (49) drei zusätzliche, jeweils symmetrisch zur Linsenlängsachse liegende, eine Brennweitenverstellung bewirkende Zusatzwicklungen (50) aufweist, von denen die mittlere Zusatzwicklung das Hauptfeld schwächt bzw. verstärkt und die anderen beiden Zusatzwicklungen das Hauptfeld verstärken bzw. schwächen, und daß zwei weitere Linsenwicklungen jeweils symmetrisch zur Linsenlängsachse vorgesehen sind, von denen die eine das Hauptfeld jeweils schwächt und die andere dasselbe jeweils verstärkt, so daß eine Beeinflussung des Hauptfeldes entsteht, die einer Längsverschiebung der Zoom-Linse (48) äquivalent ist.

14. Lithografiegerät nach einem der Ansprüche 1 bis 12, dadurch gekennzeichnet, daß die Linsen der Abbildungsoptik jeweils paarweise telezentrische Strahlengänge und entgegengesetzt gleiche Erregungen aufweisen.

15. Lithografiegerät nach einem der Ansprüche 1 bis 14, dadurch gekennzeichnet, daß der Körper (9) in einer zur Längsrichtung (23) der zeilenförmigen Lochstruktur (17 ... 22) etwa senkrechten, zu der zu strukturierenden Oberfläche des Körpers (9) parallelen Richtung (41) bewegbar angeordnet ist.

16. Lithografiegerät nach Anspruch 15, dadurch gekennzeichnet, daß der Körper (9) auf einem Drehtisch (10) befestigt ist, der um eine insbesondere im Abstand vom Körper (9) vorgesehene Achse (11) drehbar gelagert ist.

**Claims**

1. Lithography apparatus for producing microstructures on a body, in particular semiconductor body (9), having a corpuscular beam source, a condenser lens system (2, 3), a controllable aperture diaphragm (4) with a line-shaped multi-hole structure (17 to 22) for producing a plurality of corpuscular beam spots, a blanking diaphragm (5) and an optical imaging system (6, 7, OL), characterized in that the corpuscular rays form a band beam, the greatest cross-sectional dimension (12, 13) of which lies approximately in the longitudinal direction (23) of the line-shaped multi-hole structure (17 to 22) and the smallest cross-sectional dimension of which does not greatly exceed the width of the multi-hole structure.

2. Lithography apparatus according to Claim 1, characterized in that a cylindrical lens (2) producing the band beam is provided between the corpuscular beam source (1) and the aperture diaphragm (4).

3. Lithography apparatus according to Claim 1 or Claim 2, characterized in that the corpuscular beam source (1) contains a pin-shaped single-crystal cathode (1a) of secant design.

4. Lithography apparatus according to Claim 3, characterized in that the pin-shaped single-crystal cathode (1a) is made of $LaB_6$.

5. Lithography apparatus according to one of Claims 1 to 4, characterized in that the multi-hole structure of the aperture diaphragm (4) contains at least approximately rectangular or square holes (17 to 22) which extend out from a central line (23) and which are each offset to one side and the other side in an alternating manner, and in that on the sides of each hole (17) lying parallel to the central line (23), electrodes (24, 30) are arranged for deflecting the corpuscular beam spot produced by this hole.

6. Lithography apparatus according to one of Claims 1 to 4, characterized in that the multi-hole structure of the aperture diaphragm (4) contains at least approximately rectangular or square holes (32) arranged along a line (23) and being spaced from one another in accordance with their dimensions in the direction of the line (23), and in that on the sides of each hole (32) parallel to the line, electrodes (34, 35) are arranged for deflecting the corpuscular beam spot produced by this hole (32).

7. Lithography apparatus according to Claim 5 or Claim 6, characterized in that the aperture diaphragm is made of a high-impedance substrate, in particular silicon or silicon oxide, on which the electrodes (24, 30, 34, 35) are placed in the form of conductor tracks which are provided with terminals for supplying blanking voltages.

8. Lithography apparatus according to Claim 7, characterized in that the conductor tracks are made of gold.

9. Lithography apparatus according to Claim 5, characterized in that the electrodes of some or all holes (17 to 22) arranged in the region of the central line (23) are combined to a common electrode (30), the electrodes being connected to one another by means of intermediate bridges.

10. Lithography apparatus according to one of Claims 7 to 9, characterized in that the substrate on the side facing the corpuscular beam source (1) is provided outside the multi-hole structure with a conductive coating for conducting the impinging corpuscles away.

11. Lithography apparatus according to one of Claims 5 to 10, characterized in that a further aperture diaphragm (4a) is provided with further holes (17 to 22a) which correspond with respect to their position to the holes (17 to 22) of the aperture diaphragm (4) and which are penetrated by the corpuscular beam spots produced by the latter, and in that on the sides of the further holes (17 to 22a) extending perpendicularly to the line or central line (23) of the multi-hole structure, further electrodes (17b, 17c to 22b, 22c) are provided which serve to deflect the corpuscular beam spots in the direction of the line or central line (23).

12. Lithography apparatus according to one of Claims 1 to 11, characterized in that, for varying the image scale between the aperture diaphragm (4) and the semiconductor body (9), a magnetic or electrical zoom lens (48) is provided, the focal length of which and effective distance from the aperture diaphragm (4) can be varied in the same direction.

13. Lithography apparatus according to Claim 12, characterized in that the zoom lens (48), in addition to the coil (49) producing the primary field, has three additional secondary coils (50) each lying symmetrical with respect to the longitudinal axis of the lens and effecting an adjustment of the focal length, of which the middle secondary coil weakens or strengthens the primary field and the other two secondary coils strengthen or weaken the primary field respectively, and in that two further lens coils are provided in each case symmetrical with respect to the longitudinal axis of the lens, one of which in each case weakens the primary field and the other in each case strengthens said field, producing an influence on the primary field equivalent to the longitudinal displacement of the zoom lens (48).

14. Lithography apparatus according to one of Claims 1 to 12, characterized in that the lenses of the imaging optics each have pairs of telecentric beam paths and opposite equal excitations.

15. Lithography apparatus according to one of Claims 1 to 14, characterized in that the body (9) is arranged movably in a direction (41) approximately perpendicular to the longitudinal direction (23) of the rectilinear hole structure (17 to 22) and parallel to the surface of the body (9) to be structured.

16. Lithography apparatus according to Claim 15, characterized in that the body (9) is fastened on a rotary table (10) which is rotatably mounted about an axis provided in particular at a distance from the body (9).

## Revendications

1. Appareil de lithographie pour la réalisation de microstructures sur un corps, notamment un corps semi-conducteur (9), comportant une source délivrant un rayon corpusculaire, un système (2, 3) de lentilles formant condenseur, un diaphragme d'ouverture commandable (4) comportant une structure à plusieurs trous (17 à 22) disposée suivant une ligne et servant à former une multiplicité de sondes à faisceaux corpusculaires, un diaphragme de suppression (5) et un système optique (6, 7, OL) de formation d'images, caractérisé par le fait que les faisceaux corpusculaires forment un faisceau en forme de bande, dont la dimension maximale en coupe transversale (12, 13) s'étend approximativement dans la direction longitudinale (23) de la structure à trous multiples (17 à 22) disposée suivant une ligne et dont la dimension minimale en coupe transversale n'est pas très supérieure à la largeur de la structure à trous multiples.

2. Appareil de lithographie suivant la revendication 1, caractérisé par le fait qu'une lentille cylindrique (2) produisant le faisceau en forme de bande est prévue entre la source (1) du faisceau corpusculaire et le diaphragme d'ouverture (4).

3. Appareil de lithographie suivant l'une des revendications 1 ou 2, caractérisé par le fait que la source (1) du faisceau corpusculaire contient une cathode monocristalline en forme de tige (1a) qui possède une forme de taillant.

4. Appareil de lithographie suivant la revendication 3, caractérisé par le fait que la cathode monocristalline en forme de tige (1a) est constituée par du $LaB_6$.

5. Appareil de lithographie suivant l'une des revendications 1 à 4, caractérisé par le fait que la structure à trous multiples du diaphragme d'ouverture (4) comporte des évidements (17 à 22) possédant une forme au moins approximativement rectangulaire ou carrée, qui s'étendent à partir d'une ligne centrale (23) et sont décalés en alternance d'un côté et de l'autre, et que sur les côtés de chaque évidement (17), qui sont parallèles à la ligne médiane (23), se trouvent disposées des électrodes (24, 30) servant à dévier la sonde à faisceau corpusculaire produite par cet évidement.

6. Appareil de lithographie suivant l'une des revendications 1 à 4, caractérisé par le fait que la structure à trous multiples du diaphragme d'ouverture (4) comporte des évidements (32) possédant une forme au moins approximativement rectangulaire ou carrée, qui sont disposés le long d'une ligne (23) et sont séparés par des distances réciproques correspondant à leurs dimensions dans la direction de la ligne (23), et que sur les côtés de chaque évidement (32), parallèles à cette ligne, se trouvent disposées des électrodes (34, 35) servant à dévier la sonde à faisceau corpusculaire, produite par cet évidement (32).

7. Appareil de lithographie suivant l'une des revendications 5 ou 6, caractérisé par le fait que le diaphragme d'ouverture est constitué par un substrat de forte valeur ohmique, notamment en silicium ou en oxyde de silicium, sur lequel les électrodes (24, 30, 34, 35) sont disposées sous la forme de voies conductrices, qui comportent des bornes pour l'amenée de tensions de suppression.

8. Appareil de lithographie suivant la revendication 7, caractérisé par le fait que les voies conductrices sont en or.

9. Appareil de lithographie suivant la revendication 5, caractérisé par le fait que les électrodes disposées au voisinage de la ligne centrale (23), de quelques évidements ou de tous les évidements (17 à 22) sont réunies pour former une électrode commune (30), les électrodes étant reliées entre elles par des barrettes intermédiaires.

10. Appareil de lithographie suivant l'une des revendications 7 à 9, caractérisé par le fait que le substrat comporte, sur la face tournée vers la source (1) du rayon corpusculaire, à l'extérieur de la structure à trous multiples, un revêtement conducteur servant à évacuer des corpuscules incidents.

11. Appareil de lithographie suivant l'une des revendications 5 à 6, caractérisé par le fait qu'un autre diaphragme d'ouverture (4a) comporte les évidements supplémentaires (17a à 22a), dont les positions correspondent à celles des évidements (17 à 22) du diaphragme d'ouverture (4) et sont traversés par la sonde à faisceau corpusculaire produite par ces évidements et que des électrodes supplémentaires (17b, 17c à 22b, 22c), qui servent à dévier les sondes à faisceaux corpusculaires en direction de la ligne ou de la ligne centrale (23), sont disposés sur les côtés des évidements supplémentaires (17a à 22a), qui sont perpendiculaires à la ligne ou à la ligne centrale (23) de la structure à trous multiples.

12. Appareil de lithographie suivant l'une des revendications 1 à 11, caractérisé par le fait que pour modifier l'échelle de formation d'images il est prévu, entre le diaphragme d'ouverture (4) et le corps semiconducteur (9), une lentille magnétique ou électrique de zoom (48), dont la distance focale et la distance effective par rapport au diaphragme d'ouverture (4) peuvent être modifiées en des sens opposés.

13. Appareil de lithographie suivant la revendication 12, caractérisé par le fait que la lentille de zoom (48) comporte, outre l'enroulement (49) produisant le champ principal, trois enroulements supplémentaires (50), qui sont disposés symétriquement par rapport à l'axe longitudinal de la lentille et réalisent un réglage de la distance focale et parmi lesquels l'enroulement supplémentaire médian affaiblit ou renforce le champ principal et les deux autres enroulements supplémentaires renforcent ou affaiblissent le champ principal, et qu'il est prévu deux enroulements supplémentaires de la lentille, qui sont disposés symétriquement par rapport à l'axe longitudinal de cette dernière et dont l'un affaiblit le champ principal, tandis que l'autre le renforce, de sorte que le champ principal est soumis à une influence équivalente à un décalage longitudinal de la lentille de zoom (48).

14. Appareil de lithographie suivant l'une des revendications 1 à 12, caractérisé par le fait que les lentilles du dispositif optique de formation d'images possèdent des trajets de rayonnement télécentriques par couples et des excitations identiques, de signes opposés.

15. Appareil de lithographie suivant l'une des revendications 1 à 14, caractérisé par le fait que le corps (9) est disposé de manière à être déplaçable dans une direction (41) approximativement perpendiculaire à la direction longitudinale (23) de la structure à trous (17 à 22) disposée suivant une ligne, et parallèle à la surface du corps (9), qui doit être structurée.

16. Appareil de lithographie suivant la revendication 15, caractérisé par le fait que le corps (9) est fixé sur un plateau rotatif (10), qui est monté de manière à pouvoir tourner autour d'un axe (11) disposé notamment à une certaine distance du corps (9).

EP 0 191 440 B1

# FIG 1

FIG 2

FIG 3

FIG 4

# FIG 5

# FIG 6

# FIG 7